# EUROPEAN PATENT APPLICATION

(11) **EP 2 133 914 A2**
(43) Date of publication of application: **16.12.2009**
(21) Application number: 09007426.1
(22) Date of filing: 04.06.2009
(51) Int. Cl.: H01L 23/427, F28D 15/02

(54) **Heat dissipation module**

(30) Priority: 12.06.2008 TW 97210413 U
(71) Applicant: Acpa Energy Conversion Devices Co.,Ltd., Jhonghe City T'ai pei 23552 (TW)
(72) Inventor: Yao, Pei-Chih, Jhonghe City Taipei County 23552 (TW)
(74) Representative: Zeitler, Giselher

(57) **Abstract**

The present invention relates a heat dissipation module applied to a microprocessor or light-emitting diodes. The heat dissipation module is provided with at least one heat-conducting column, on at least one end of which an outwardly extending expanded element is provided and on the periphery of which a heat-dissipating element is provided. Insuchmanner, when the heat dissipation module is used for heat dissipation of a microprocessor, the area in contact with a heat source is enlarged by the expanded element, with rapid heat dissipation through the heat -conducting column and the heat-dissipating element. Moreover, when the heat dissipation module is used for light-emitting diodes, the expanded element can increase the heat dissipation area and the number of light-emitting diodes positioned to accelerate heat dissipation.

## Description

### BACKGROUND OF THE INVENTION

### (a) Field of the Invention

The present invention relates a heat dissipation module, which is applied to a microprocessor or light -emitting diodes to enlarge the area in contact with a heat source or to increase the area or number of light -emitting diodes positioned thereby improving heat dissipation effect and increasing light-emitting luminance.

### (b) Description of the Prior Art:

Computers have become ubiquitous tools in modern life. However, with the fast development of computer technology, computer manufacturers continue looking for hardware with a faster computing speed and with better performance. At the same time, computer manufacturers are also confronted with the problem of heat dissipation in microprocessors due to more and more heat generated by faster and faster microprocessors.

Likewise, different from common lamp light sources in daily life, such as conventional light bulbs, quartz bulbs, daylight bulbs, mercury lamps and the like, light -emitting diodes belong to cold light emission devices, and have the advantages of low power consumption, long lifetime, and fast response speed, etc. In addition, they have small dimensions, can endure shocks, and are suitable for mass production. Thus, light-emitting diodes have become indispensable and important components in daily life. Besides, more and more attention will be given to high-luminance LEDs. Nevertheless, due to the problem of current-to-light conversion efficiency, high heat is generated when in use and sustained high heat causes damage to electronic components. It is necessary to assemble multiple LEDs to serve as a high-luminance or lighting fixture so that the amount of generated heat will increase.

Accordingly, to solve the above heat dissipation problems of microprocessors in computers or light-emitting diodes for lighting has also become the most important subject to those manufacturers.

### SUMMARY OF THE INVENTION

To solve the various drawbacks of the prior art, the inventors made efforts on research and experiments for a long time and has finally developed and designed a heat dissipation module.

It is an object of the present invention to provide a heat dissipation module used for a microprocessor or light-emitting diodes. The heat dissipation module is provided thereon with a heat-conducting column. An outwardly extending expanded element is provided on at least one end of the heat-conducting column. On the periphery of the heat-conducting column is provided a heat-dissipating element. In such manner, the heat -conducting column and the heat-dissipating element allow rapid heat dissipation, and the expanded element can enlarge the contact area with a heat-generating source to accelerate heat dissipation.

Another obj ect of the present invention is to provide a heat dissipation module whose loading area is enlarged by the expanded element to increase the number of light-emitting diodes positioned.

Yet another object of the present invention is to provide a heat dissipation module in which expanded elements are provided at the two ends of the heat-conducting column respectively and the heat-dissipating element is disposed between the expanded elements and in contact with each of the expanded elements, resulting thermal reflux effect, so as to speed up heat dissipation.

Still another object of the present invention is to provide a heat dissipation module in which the end surface of the expanded element is beveled from the outside to the inside or from the inside to the outside, thereby improving the effect of collecting or diffusing light.

Another obj ect of the present invention is to provide a heat dissipation module in which at least two heat -conducting columns are provided and correspond to each other. An outwardly extending heat-dissipating element is provided on the outer side of each of the heat-conducting columns, and a connection element is provided between the heat-conducting columns. The connection element is made of a thermal conductive material. In such manner, the heat -conducting columns are integrated into one piece via the connection element so as to accelerate heat dissipation.

### BRIEF DESCRIPTION OF THE DRAWINGS

The objects, shapes, structures, configurations, features and effects of present invention will be further understood and appreciated from the following detailed description when taken in conjunction with the drawings according to exemplary embodiments:
FIG. 1 is a schematic three-dimensional view of a first embodiment of the present invention.
FIG. 2 is a schematic cross-sectional view of a first embodiment of the present invention.
FIG. 3 is a schematic cross-sectional view of a second embodiment of the present invention.
FIG. 4 is a schematic three-dimensional view of a third embodiment of the present invention.
FIG. 5 is a schematic assembly drawing of a fourth embodiment of the present invention.
FIG. 6 is a schematic three-dimensional exploded view of a fifth embodiment of the present invention.
FIG. 7 is a schematic three-dimensional assembly drawing of a fifth embodiment of the present invention.
FIG. 8 is a schematic three-dimensional exploded view of a sixth embodiment of the present invention.
FIG. 9 is a schematic view of a seventh embodiment of the present invention.
FIG. 10 is a schematic view showing the practice of an eighth embodiment of the present invention.

### DETAILED DESCRIPTION OF THE PREFERRED EMBODIMENTS

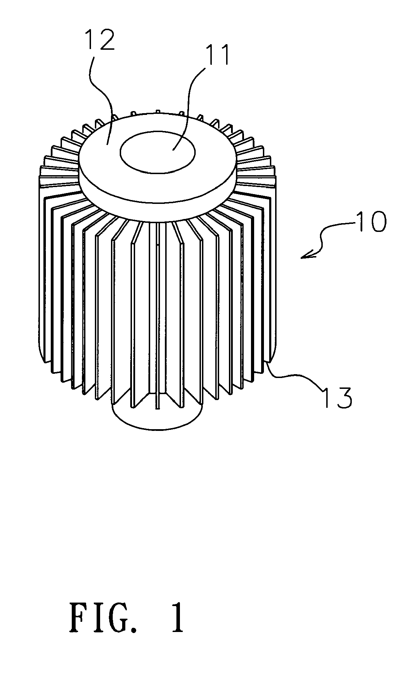

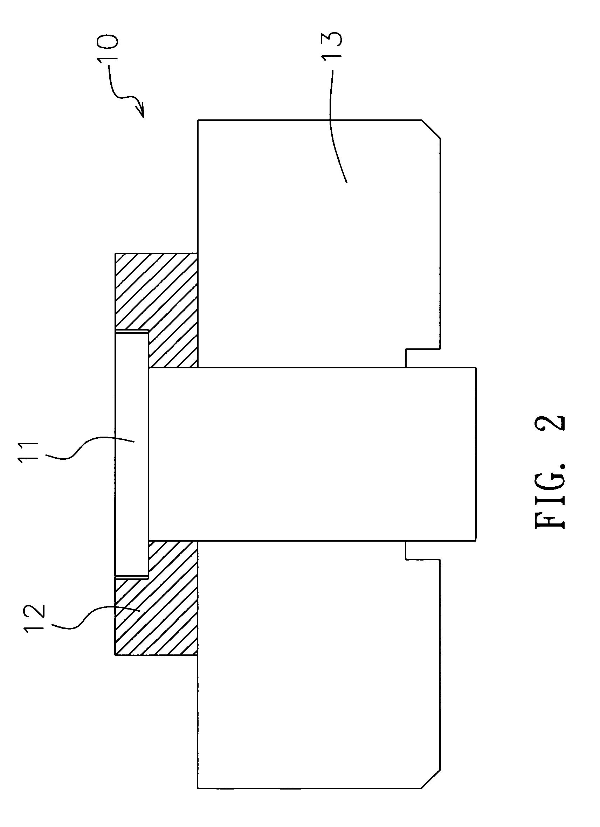

The present invention relates a heat dissipation module 10 that can be used for heat dissipation of a microprocessor. Referring to the first embodiment, shown in FIGS. 1 and 2, the heat dissipation module 10 is provided with a heat-conducting column 11 (which is made of a thermal conductive material and can be a heat pipe or a heat column, and which is a heat pipe in this embodiment). The heat -conducting column 11 quickly transfers the temperature from a heat source end to the other end under a specific temperature condition. On at least one end of the heat -conducting column 11 (on the bottom end in this embodiment) is provided an outwardly extending expanded element 12 (which is made of a single or composite thermal conductive material). The end surface of the expanded element 12 is planar. On the periphery of the heat-conducting column 11 is provided outwardly extending heat-dissipating elements 13 (which are made of a single or composite thermal conductive material and are heat-dissipating blocks or heat-dissipating fins, and which are radial heat-dissipating fins in this embodiment). In such manner, the heat-conducting column 11 and the heat-dissipating elements 13 not only can allow rapid heat dissipation, but the expanded element 12 also can enlarge the contact area with a heat-generating source to accelerate heat dissipation.

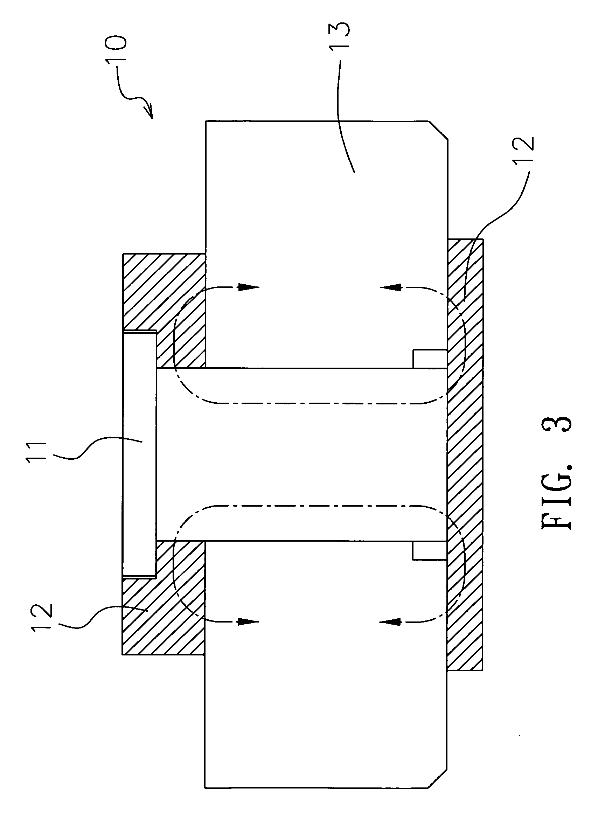

Referring to FIG. 3, there is shown a heat dissipation module 10 that can be used for heat dissipation of a microprocessor or light-emitting diodes, which is the second embodiment of the present invention. This embodiment differs from the first embodiment in that: outwardly extending expanded elements 12 are provided at the two ends of the heat-conducting column 11 respectively and the heat-dissipating elements 13 are disposed between the expanded elements 12 and respectively in contact with the expanded elements, resulting thermal reflux effect, so as to speed up heat dissipation.

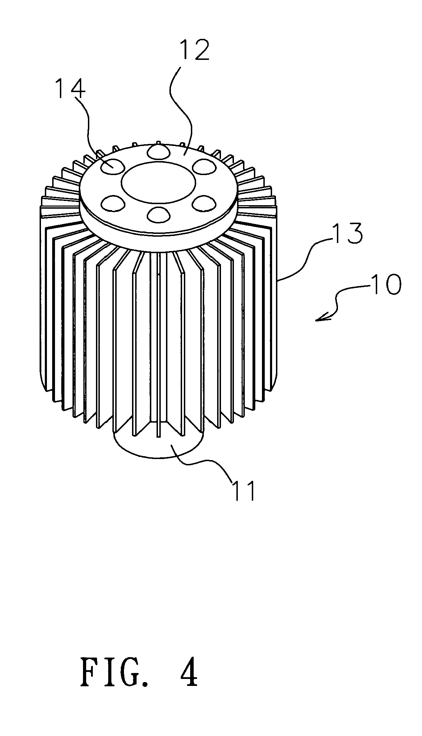

Referring to FIG. 4, there is shown a heat dissipation module 10 that is used for heat dissipation of light -emitting diodes, which is the third embodiment of the present invention. It differs from the above embodiments in that: on at least one end of the heat-conducting column 11 of the heat dissipation module 10, on the top end in this embodiment, is provided an outwardly extending expanded element 12. The end surface of the expanded element 12 is planar. Light-emitting diodes 14 are disposed on the expanded element 12. In such manner, the expanded element 12 enlarges the area to increase the number of light-emitting diodes positioned and accelerate heat dissipation.

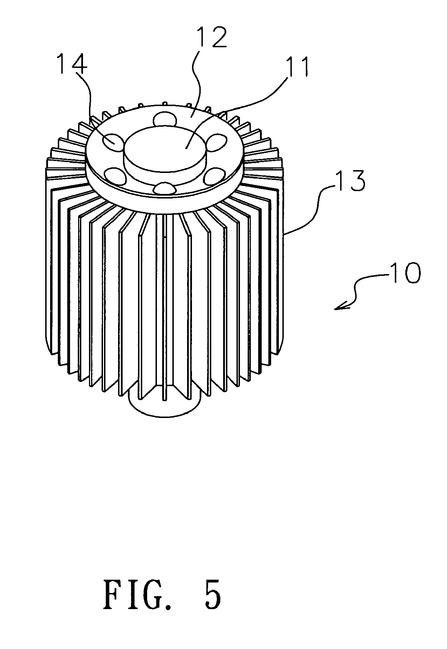

Referring to FIG. 5, there is similarly shown a heat dissipation module 10 that is used for heat dissipation of light-emitting diodes, which is the fourth embodiment of the present invention. It differs from the third embodiment of the present invention in that: the end surface of the expanded element 12 is beveled from the outside to the inside (or beveled from the inside to the outside), such that the bevel angle of the expanded element 12 can improve the effect of collecting light (or diffusing light) when the light-emitting diodes 14 are mounted thereon.

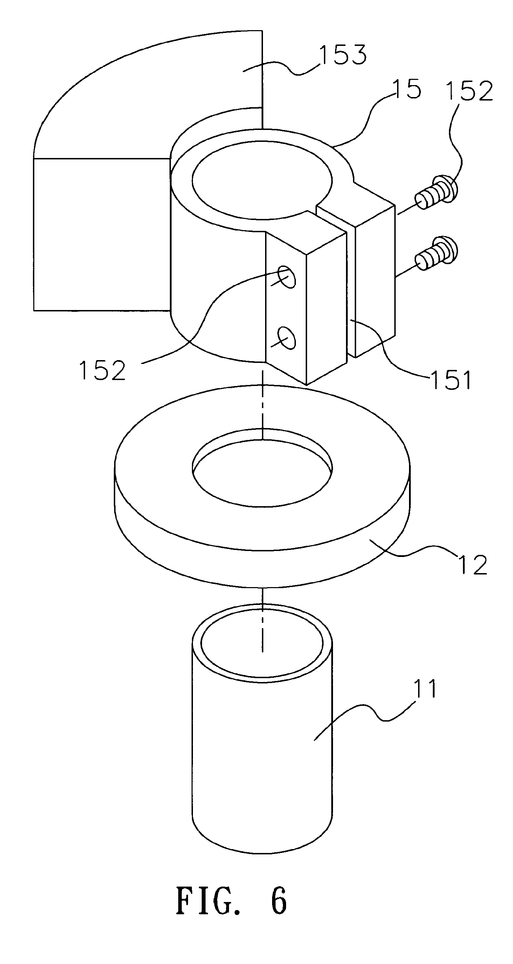

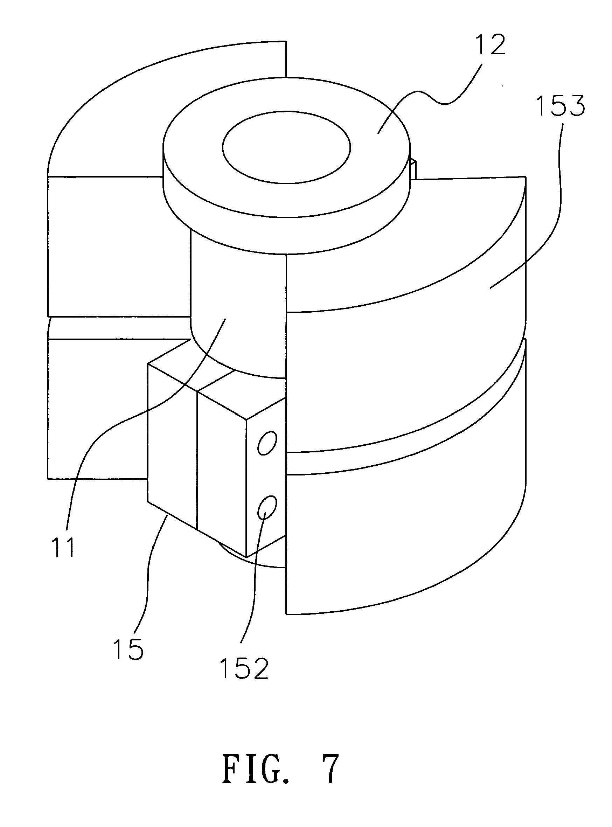

Referring to FIG. 6, there is shown a heat dissipation module 10 that is used for heat dissipation of light -emitting diodes or a microprocessor, which is the fifth embodiment of the present invention. It is provided with a heat-conducting column 11. The heat-conducting column 11 is made of a thermal conductive material, and may be a heat pipe, or may also be a heat column in this embodiment. An outwardly extending expanded element 12 is provided at one end of the heat-conducting column 11, which is an annular frame in this embodiment. A collar 15 is disposed on the heat-conducting column 11 and provided with a notch 151. Fixed members 152 are respectively provided at the two ends of the notch 151 (which are mutually fitted threaded holes and screws in this embodiment and, however, those skilled in the art can still join them by welding or other means) such that the collar 15 is secured on the periphery of the heat-conducting column 11 by mutually locking the fixed members 152 when it is put around the heat-conducting column 11. Some region of the collar 15 is provided with an outwardly developed fan-shaped heat -dissipating element 153, such as heat-dissipating fin or heat-dissipating block. In this embodiment, the heat -dissipating element is a heat-dissipating block. The end of the heat-conducting column 11 at which the expanded element 12 is disposed may be in contact with a heat-generating source when in use. In such manner, the heat-conducting column 11 and the heat-dissipating element 153 not only can allow rapid heat dissipation, but the expanded element 12 also can increase the contact area with the heat-generating source to accelerate heat dissipation. Moreover, further fan-shaped heat -dissipating elements 153 may be added to the same collar 15, or more than one of the collar 15 may be added (as shown in FIG. 7), if required.

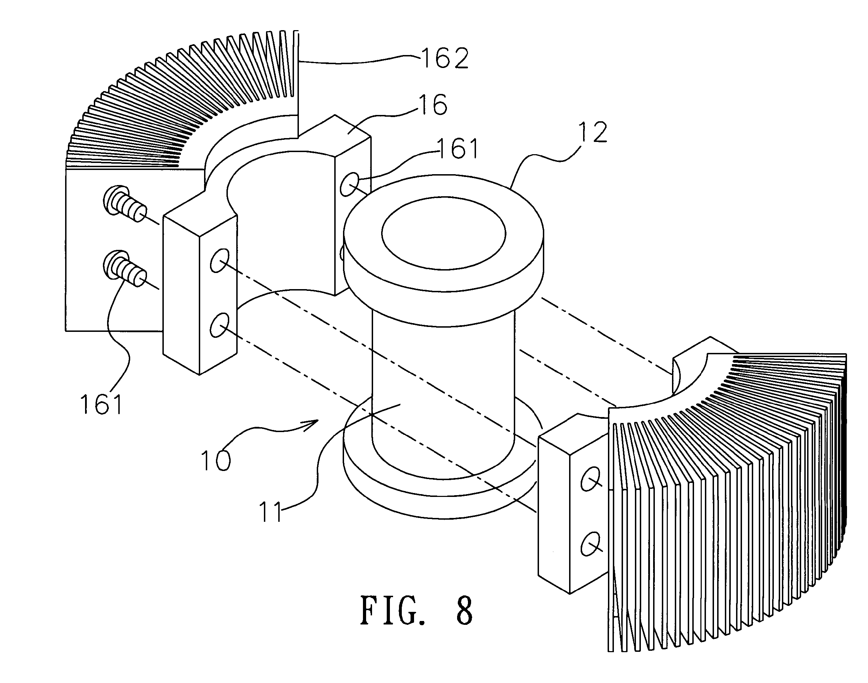

Referring to the sixth embodiment, shown in FIG. 8, the heat dissipation module is provided with a heat -conducting column 11 that is a cylinder in this embodiment. Outwardly extending expanded elements 12 are provided at both two ends of the heat-conducting column 11, each of which is an annular frame in this embodiment. Opposing heat-dissipating blocks 16 are disposed on the heat -conducting column 11. Fixed members 161 are respectively provided at the two ends of the heat-dissipating blocks 16 (which are mutually fitted threaded holes and screws in this embodiment and, however, those skilled in the art can still join them by welding or other means) such that the heat-dissipating blocks 16 are clamped on the periphery of the heat-conducting column 11 by mutually locking the fixed members 161 when they are attached against the heat -conducting column 11. The peripheries of the heat -dissipating blocks 16 are respectively provided with outwardly developed fan-shaped heat-dissipating elements 162. In such manner, the heat-conducting column 11 and the heat-dissipating elements 162 not only can allow rapid heat dissipation, but the expanded element 12 also can increase the contact area with the light-emitting diodes to accelerate heat dissipation.

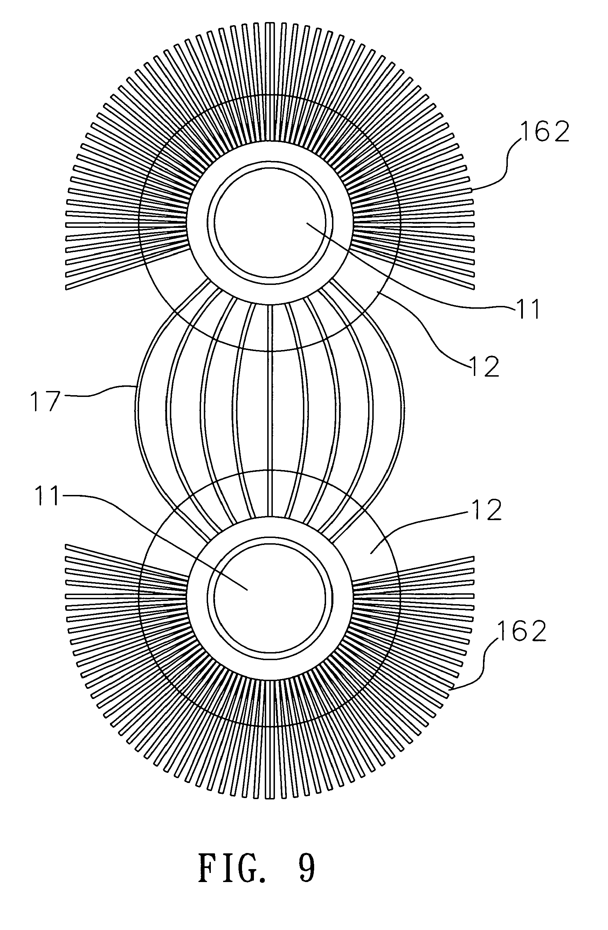

Referring to the seventh embodiment, shown in FIG. 9, it is different from each of the above embodiments in that: at least two heat-conducting columns 11 are provided and correspond to each other and an outwardly extending heat-dissipating element is provided on the outer side of each of the heat-conducting columns 11. Furthermore, a connection element 17 is provided between the heat -conducting columns 11. The connection element 17 is made of a thermal conductive material. In such manner, the heat -conducting columns 11 are integrated into one piece via the connection element 17 so as to speedup heat dissipation.

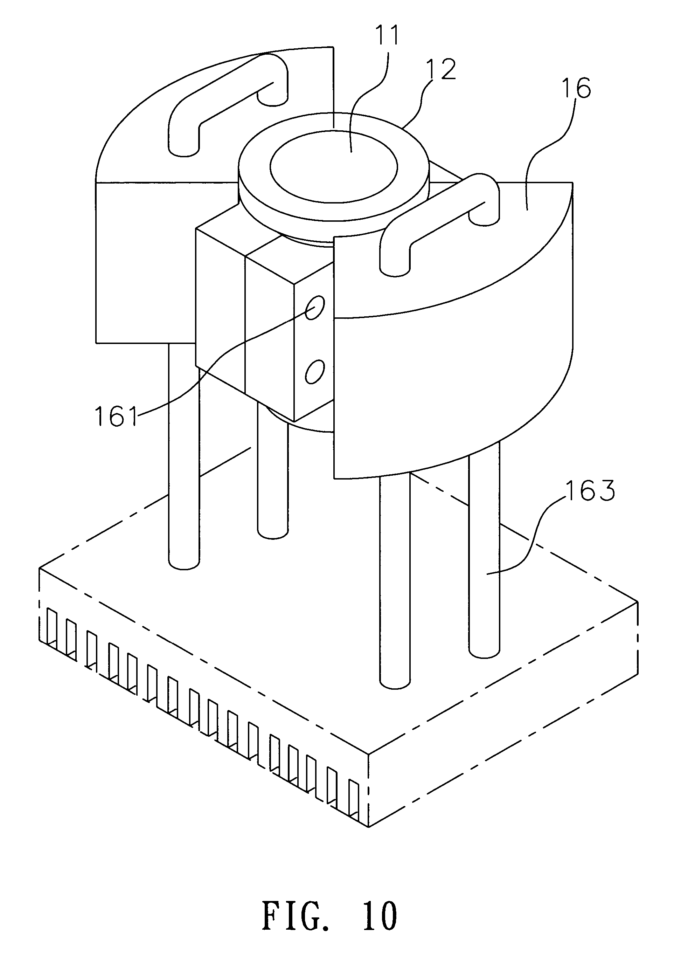

Referring to the eighth embodiment, shown in FIG. 10, the heat dissipation module is provided with a heat -conducting column 11 that is a cylinder in this embodiment. Outwardly extending expanded elements 12 are provided at the two ends of the heat-conducting column 11, each of which is an annular frame in this embodiment. Opposing heat-dissipating elements are disposed on the heat -conducting column 11. In this embodiment, the heat -dissipating elements are heat-dissipating blocks 16. Fixed members 161 are respectively provided at the two ends of the heat-dissipating blocks 16 (which are mutually fitted threaded holes and screws in this embodiment and, however, those skilled in the art can still join them by welding or other means) such that the heat-dissipating blocks 16 are clamped on the periphery of the heat -conducting column 11 by mutually locking the fixedmembers 161 when they are attached against the heat-conducting column 11. The heat-dissipating blocks 16 are provided at their end sides with heat-conducting pipes 163 to extend to other spaces or to another heat-dissipating element for heat dissipation.

## Claims

1. A heat dissipation module comprising:
at least one substantially columnar heat-conducting column;
at least one hollow expanded element provided at any end of the heat-conducting column; and
at least one heat-dissipating element fixed on the periphery of the heat-conducting column.

2. The heat dissipation module as claimed in claim 1, wherein the heat-conducting column is a heat pipe.

3. The heat dissipation module as claimed in claim 1, wherein the heat-conducting column is a heat column.

4. The heat dissipation module as claimed in claim 1, wherein the end surface of the expanded element is a planar surface.

5. The heat dissipation module as claimed in claim 1, wherein the end surface of the expanded element is beveled from the outside to the inside.

6. The heat dissipation module as claimed in claim 1, wherein the end surface of the expanded element is beveled from the inside to the outside.

7. The heat dissipation module as claimed in claim 1, wherein the heat-dissipating element is coupled to a collar mounted around the heat-conducting column.

8. The heat dissipation module as claimed in claim 1, wherein the heat-dissipating element is a heat -dissipating block or a heat-dissipating fin.

9. The heat dissipation module as claimed in claim 1, wherein two expanded elements are further provided at the two ends of the heat-conducting column respectively and the heat-dissipating element is disposed between the expanded elements.

10. The heat dissipation module as claimed in claim 9, wherein the heat-dissipating element is in contact with each of the expanded elements.

11. The heat dissipation module as claimed in claim 1, wherein the heat-dissipating element is provided at its end side with a heat-conducting pipe.

12. The heat dissipation module as claimed in claim 1, wherein two heat-conducting columns are provided and correspond to each other, an outwardly extending heat -dissipating element is provided on the outer side of each of the heat-conducting columns, and a connection element is provided between the heat-conducting columns.

13. The image display method as claimed in claim 12, wherein the connection element is made of a thermal conductive material.
